# EUROPÄISCHE PATENTSCHRIFT

(11) **EP 0 932 254 B1**
(45) Veröffentlichungstag und Bekanntmachung des Hinweises auf die Patenterteilung: **12.05.2004**
(21) Anmeldenummer: 99200122.2
(22) Anmeldetag: 15.01.1999
(51) Int. Cl.: H03G 5/12

(54) **Schaltungsanordnung für einen verstellbaren Hochpass**
Adjustable highpass circuit
Circuit filtre passe-haut ajustable

(30) Priorität: 21.01.1998 DE 19802037
(43) Veröffentlichungstag der Anmeldung: 28.07.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Jabs, Hermann, Röntgenstrasse 24, 22335 Hamburg (DE)
(74) Vertreter: Peters, Carl Heinrich, Dipl.-Ing.

(56) Entgegenhaltungen:
- US-A- 5 406 636
- US-A- 5 485 122
- US-A- 5 937 071

## Beschreibung

Die Erfindung bezieht sich auf eine Schaltungsanordnung für einen verstellbaren Hochpaß, die einen Hauptpfad zum Führen eines Hauptstromes mit einem ersten Widerstand, der ausgangsseitig an einem Summenknoten angeschlossen ist, einen Nebenpfad zum Führen eines Nebenstromes über eine Spannungsteilereinheit, eine erste Verstärkerstufe, deren Ausgang auf invertierende Eingänge der ersten Verstärkerstufe gekoppelt ist und einen Kondensator, der zwischen den Ausgang der ersten Verstärkerstufe und den Summenknoten geschaltet ist und einen zweiten Widerstand, der am Summenknoten angeschlossen ist, wobei am Summenknoten der Hauptstrom und der Nebenstrom addiert werden, enthält.

In herkömmlichen Systemen von Rundfunkempfängern oder in Autoradios werden durch die Selektivität der verwendeten Keramikfilter Übertragungsfehler für höhere Frequenzen im Audio-Basis-Band verursacht. Diese führen nach der Dekodierung des Signals im Stereodekoder zu unsymmetrischem bzw. schlechtem Übersprechen zwischen dem rechten und linken Kanal und werden durch einen abgleichbaren Hochpaß kompensiert. Die zu dekodierenden Signale werden in Keramikfiltern gefiltert, die neben Abweichungen ihrer Kenndaten auch einen Tiefpaßeffekt haben, wodurch eine Vergrößerung des ungleichmäßigen Übersprechens der beiden Kanäle eines Stereosignals hervorgerufen wird.

In der "Electronics" March 10, 1981, Seite 191-192 ist ein System beschrieben, in dem mit veränderbaren Parametern die Filtereigenschaften verändert werden. Die durch die Filter geleiteten Signalanteile werden nach ihrer Beeinflussung in einer Verstärkerstufe wieder dem Hauptanteil des Signals beigemischt und deren Verläufe addiert. Die Filter enthalten jedoch Bauelemente, die sich aufgrund ihrer Größe nicht integrieren lassen. Außerdem entsteht am Mischpunkt ein Gleichspannungsoffset zum Basissignal, so daß bei der Addition ein Klirrfaktor das gewünschte Signal verfälscht. Als Bezugspotential wird Masse verwendet.

In der EP 0 091 160 wird ein System beschrieben, bei dem der nichtinvertierende Eingang einer Verstärkerstufe mit einem Spannungsteiler verbunden ist. Die Teilspannungen werden über einen Umschalter mit dem nichtinvertierenden Eingang verbunden. Auch der invertierende Eingang ist über einen weiteren Umschalter mit einem weiteren Spannungsteiler verbunden, über den der invertierende Eingang mit dem Ausgang gekoppelt ist.

Aus einem empfangenen Frequenzband wird ein Sender herausgefiltert. Dazu werden Keramikfilter verwendet. Oft werden dazu auch mehrere Keramikfilter in einer Kette mit zwischengeschalteten Verstärkerstufen hintereinander geschaltet. Keramikfilter haben den Nachteil, daß die Werte ihrer Kenndaten streuen. Außerdem wird durch die Benutzung von Keramikfiltern ein Tiefpaßeffekt hervorgerufen, der das Frequenzband des Stereosignals ungleichmäßig begrenzt. Die durch diese Selektivität verursachten Übertragungsfehler werden für höhere Frequenzanteile mit einem abgleichbaren Hochpaß kompensiert. Diese Übertragungsfehler führen nach der Dekodierung des Signals im Stereodekoder zu einem unsymmetrischen bzw. schlechten Übersprechen der beiden Audiokanäle. Nachteilig bei den bereits bestehenden Schaltungen ist, daß für die abgleichbaren Hochpässe externe Potentiometer verwendet werden und dadurch für jede Schaltung bzw. für jedes Gerät ein Extraabgleich vorgenommen werden muß. Externe Potentiometer sind nicht alterungsbeständig, womit eine ständige Veränderung der Übertragungsfunktion hervorgerufen wird. Die Integration großer Kapazitäten ist bisher nicht realisierbar. Der Bezug auf Masse als Bezugspotential ist nachteilig, da die Systemmasse mit Störungen behaftet ist. Weiterhin läßt sich ein solches Bezugspotential nicht in seinem Wert verändern.

Aufgabe ist es deshalb, eine Schaltungsanordnung anzugeben, die eine Korrektur der durch die Selektivität entstandenen Übertragungsfehler vornimmt, ohne die Qualität des Signals zu mindern und die integrierbar ist.

Erfindungsgemäß wird diese Aufgabe mit einer Schaltungsanordnung der eingangs genannten Art gelöst, bei der nichtinvertierende Eingänge der ersten Verstärkerstufe jeweils an Verbindungen zwischen Widerständen der Spannungsteilereinheit angeschlossen sind und über eine Auswahleinheit ein nichtinvertierender Eingang auswählbar ist und die Spannungsteilereinheit und der zweite Widerstand an ein einstellbares, rauscharmes Bezugspotential angeschlossen sind.

Die durch Keramikfilter hervorgerufenen Übertragungsfehler werden mit einem abgleichbaren Hochpaß kompensiert. Das zu filternde Eingangssignal mit aufgeprägter Tiefpaßcharakteristik wird über eine am Eingang der Schaltungsanordnung liegende zweite Verstärkerstufe geführt. Bevor dieses Signal einer Stereo-Dekoderstufe zugeführt wird, wird es über diesen abgleichbaren Hochpaß geführt. Dieser Hochpaß enthält prinzipiell einen ersten Widerstand, dem ein veränderbarer Kondensator parallelgeschaltet ist, und einen zweiten Widerstand. Das Signal wird in einen Haupt- und einen Nebenstrom aufgeteilt. Dabei wird der Hauptstrom über den ersten Widerstand geführt und der Nebenstrom über den veränderbaren Kondensator. Beide Ströme werden an einem am Ausgang des Hochpaß liegenden Summenknoten addiert. An diesen Summenknoten ist der zweite Widerstand angeschlossen, der gleichzeitig die Verbindung zu einem Bezugspotential bildet. Der veränderbare Kondensator ist durch eine Spannungsteilereinheit, eine erste Verstärkerstufe und einen Kondensator der an einer von der Verstärkerstufe veränderbaren Spannung anliegt, realisiert. Die erste Verstärkerstufe wird an ihren nichtinvertierenden Eingängen mit jeweils unterschiedlichen Teilspannungen der vorgeschalteten Spannungsteilereinheit verbunden. Die mehreren nichtinvertierenden Eingänge der Verstärkerstufe werden über eine Auswahleinheit ausgewählt. Die zusammengefaßten invertierenden Eingänge sind als Gegenkopplung mit dem Ausgang der Verstärkerstufe verbunden. Wenn über die Auswahleinheit ein nichtinvertierender Eingang der ersten Verstärkerstufe, der mit einer Verbindung zwischen jeweils zwei Widerständen am Spannungsteiler verbunden ist, ausgewählt wird, verändert sich die Spannung am Ausgang der ersten Verstärkerstufe und damit auch der Nebenstrom, der am Summenknoten zum Hauptstrom addiert wird.

Das Bezugspotential an das der zweite Widerstand und die Spannungsteilereinheit angeschlossen sind, ist einstellbar und rauscharm. Es wird aus einer externen Referenzspannung gebildet, die einer dritten Verstärkerstufe zugeführt wird. Durch Änderung der externen, nicht mit Störsignalen behafteten Referenzspannung kann das Bezugspotential an schaltungstechnische Besonderheiten angepaßt werden.

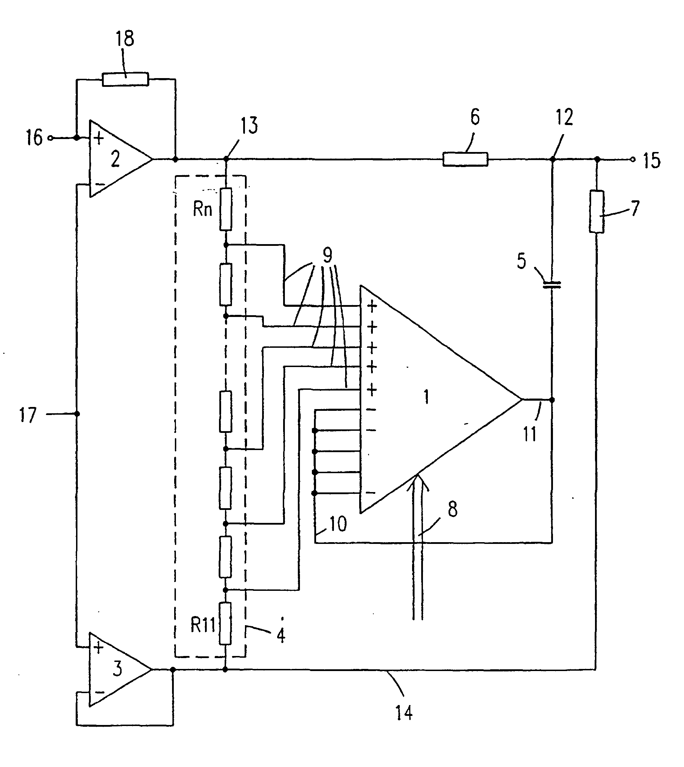

Die Auswahleinheit, die vorzugsweise mit einem I²C-Bus realisiert ist, wählt die nichtinvertierenden Eingänge an der ersten Verstärkerstufe aus. Dadurch liegt als Eingangssignal für diese erste Verstärkerstufe eine Teilspannung von der vorgeschalteten Spannungsteilereinheit an. Die erste Verstärkerstufe enthält mehrere invertierende und nichtinvertierende Eingänge. Über die Auswahleinheit werden Stromquellentransistoren, wie in der EP 0 091 160 (Fig.7), angesteuert, die die Eingangstransistorenpaare der jeweiligen nichtinvertierenden Eingänge aktivieren.

Die Spannungsteilereinheit enthält mehrere Widerstände, die linear oder nichtlinear gestaffelt sind. Mit der Staffelung wird eine entsprechende Anzahl von unterschiedlichen Übertragungsfunktionen des Hochpasses realisiert. Die Anzahl der schaltbaren Teilspannungen bestimmt die Anzahl der realisierbaren Übertragungsfunktionen des Hochpasses.

Die zweite Verstärkerstufe wird mit einem Eingangssignal an ihrem nichtinvertierenden Eingang angesteuert. Dieses Eingangssignal enthält Frequenzanteile des empfangenen Frequenzbandes und ist durch die Tiefpaßcharakteristik von Keramikfiltern in seinen höheren Frequenzen begrenzt.

Am Ausgang der zweiten Verstärkerstufe wird das verstärkte Eingangssignal in einen Hauptstrom und einen Nebenstrom aufgeteilt. Der Ausgang der zweiten Verstärkerstufe ist auf den nichtinvertierenden Eingang zurückgekoppelt. Am invertierenden Eingang der zweiten Verstärkerstufe wird die externe Referenzspannung angelegt.

Durch diesen integrierbaren Hochpaß läßt sich das Signal am Summenknoten in Amplitude und Phase korrigieren. Von der Verstärkerstufe und dem Kondensator wird nur der Nebenstrom beeinflußt. Durch die Wahl einer entsprechenden Teilspannung an der Spannungsteilereinheit läßt sich die Spannung, die am Kondensator anliegt, stufenweise verändern. Im Ergebnis ist dies einer Variation der Kapazität gleichzusetzen. Somit wird ein verstellbarer Hochpaß realisiert, der in seiner Übertragungsfunktion an Anforderungen angepaßt werden kann. Übertragungsfehler können durch die Beeinflussung von Amplitude und Phase am Summenknoten behoben werden. Über den Kondensator wird kein Gleichspannungsoffset übertragen, da der Gleichspannungsarbeitspunkt des Nebenstromes erst an diesem Summenknoten entsteht.

Nachfolgend wird ein Ausführungsbeispiel der Erfindung anhand der Figur näher erläutert. Die Figur zeigt eine Schaltungsanordnung für einen abgleichbaren Hochpaß.

Die Figur enthält drei Verstärkerstufen 1, 2 und 3, eine Spannungsteilereinheit 4, einen Kondensator 5, Widerstände 6, 7 und 18, eine Auswahleinheit 8, nichtinvertierende Eingänge 9, invertierende Eingänge 10 und das Ausgangssignal 11 der Verstärkerstufe 1.

Die Verstärkerstufen 1,2 und 3 sind jeweils als Operationsverstärker ausgeführt. Der Operationsverstärker 2 am Eingang 16 der Schaltungsanordnung verstärkt das von Keramikfiltern kommende Signal mit einem Verstärkungsfaktor k. Dieses verstärkte Eingangssignal wird am Punkt 13 in einen Haupt- und in einen Nebenstrom geteilt.

Der Nebenstrom wird über eine Spannungsteilereinheit 4, die aus Widerständen R₁₁ bis Rₙ besteht, zu jeweils einem nichtinvertierenden Eingang geschaltet. Die Verbindungspunkte zwischen den einzelnen Widerständen R₁₁ bis Rₙ sind jeweils auf nichtinvertierende Eingänge 9 des Operationsverstärkers 2 geführt. Die invertierenden Eingänge 10 sind miteinander verbunden und auf den Ausgang 11 des Operationsverstärkers 1 geführt. An diesen Ausgang 11 ist der Kondensator 5 angeschlossen. Über den Kondensator 5 wird der Nebenstrom zum Summenknoten 12 geführt. Der Summenknoten 12 stellt gleichzeitig den Ausgang 15 des Hochpasses dar. Zwischen dem Punkt 13 und dem Summenknoten 12 ist ein ohmscher Widerstand 6 angeordnet, über den der Hauptstrom geführt wird. Ein weiterer ohmscher Widerstand 7 ist vom Summenknoten 12 zu einem gemeinsamen Bezugspotential 14 geschaltet. Dieses gemeinsame Bezugspotential 14 wird durch den Ausgang des Operationsverstärkers 3 gebildet.

Über die Auswahleinheit 8, die als I²C- Bus ausgeführt ist, wird der Operationsverstärker 1 in der Weise gesteuert, daß einer der nichtinvertierenden Eingänge 9 ausgewählt wird und die dadurch anliegende Teilspannung, die an der Spannungsteilereinheit 4 entsteht, die Eingangsspannung für den Operationsverstärker 1 darstellt. Zu jedem nichtinvertierenden Eingang gehört ein Differenzverstärker, die hier nicht dargestellt sind. Diese dem jeweiligen nichtinvertierenden Eingang zugeordneten Differenzverstärker werden über je einen als Stromquelle geschalteten Transistor aktiviert. Durch die unterschiedlichen wählbaren Teilspannungen entsteht ein von diesen Teilspannungen abhängiger veränderbarer Strom am Ausgang 11 des Operationsverstärkers 1, der über den Kondensator 5 dem Summenknoten 12 zugeführt wird. Der Hauptstrom der vom Ausgang des Operationsverstärkers 2 über den Widerstand 6 zum Summenknoten 12 geführt wird, ist durch eine Tiefpaßcharakteristik gekennzeichnet. Durch die Anordnung des Kondensators 5, des Operationsverstärkers 1 und der Spannungsteilereinheit 4 erreicht man, daß der Nebenstrom in seiner Amplitude und auch in seiner Phase steuerbar ist, so daß das Ausgangssignal 15 des Hochpasses, welches einem Stereodekoder zugeführt wird, als resultierendes Signal aus dem Hauptstrom und dem Nebenstrom gebildet wird und der Hauptstrom mit der Tiefpaßcharakteristik und den Übertragungsfehlern durch das amplituden- und phasenkorrigierte Signal des Nebenstroms berichtigt wird. Durch den stufenweise veränderbaren Strom durch den Kondensator 5 wird ein Ergebnis erzielt, welches einer Variation der Kapazität des Kondensators 5 gleichkommt, womit in der Gesamtfunktion ein verstellbarer Hochpaß realisierbar ist. Durch die Steuerung der Teilspannung an den nichtinvertierenden Eingängen 9 des Operationsverstärkers 1 über die Auswahleinheit 8 läßt sich so eine gewünschte Filterkennlinie für diesen Hochpaß einstellen, so daß das am Eingang 16 ankommende Signal mit seinen Übertragungsfehlern in Phase und Amplitude korrigiert werden kann und somit die Übertragungsfehler im Stereodekoder nicht zu einem ungleichmäßigen Übersprechen zwischen dem rechten und dem linken Kanal führen.

Mit dem dritten Operationsverstärker 3 wird ein einstellbares rauscharmes Bezugspotential geschaffen. Der Operationsverstärker 3 wird an seinem nichtinvertierenden Eingang mit einer externen Referenzspannung 17 verbunden. Diese Referenzspannung 17 liegt bei etwa 3,7 V, also zwischen Betriebsspannung und Masse. Der Ausgang des Operationsverstärkers 3 ist auf seinen invertierenden Eingang gekoppelt. Das am Ausgang des Operationsverstärkers 3 anliegende Bezugspotential 14, läßt sich durch Änderung der externen Referenzspannung 17 in positive und negative Richtungen verschieben. An dieses Bezugspotential 14 sind die Spannungsteilereinheit 4 und der zweite Widerstand 7 angeschlossen. Auf diese Weise entsteht ein Bezugssignal, welches frei von Störungen ist und auf dem keine Signale übertragen werden. Der Operationsverstärker 2 wird an seinem invertierenden Eingang mit dieser externen Referenzspannung 17 versorgt.

Die Spannungsteilereinheit 4 kann eine lineare Aufteilung aufweisen. Basierend auf dieser Aufteilung entstehen die entsprechenden Übertragungsfunktionen des Hochpasses. Mit der Wahl der Größe der zu integrierenden Kapazität des Kondensators 5 wird der Bereich festgelegt, in dem sich die Übertragungsfunktionen des Hochpasses verändern lassen.

## Patentansprüche

1. Schaltungsanordnung für einen verstellbaren Hochpaß die enthält:
- einen Hauptpfad zum Führen eines Hauptstromes mit einem ersten Widerstand, der ausgangsseitig an einem Summenknoten angeschlossen ist,
- einen Nebenpfad zum Führen eines Nebenstromes über eine Spannungsteilereinheit, eine erste Verstärkerstufe, deren Ausgang auf invertierende Eingänge der ersten Verstärkerstufe gekoppelt ist und einen Kondensator, der zwischen den Ausgang der ersten Verstärkerstufe und den Summenknoten geschaltet ist,
- einen zweiten Widerstand, der am Summenknoten angeschlossen ist, wobei am Summenknoten der Hauptstrom und der Nebenstrom addiert werden,
**dadurch gekennzeichnet, daß**
- nichtinvertierende Eingänge der ersten Verstärkerstufe jeweils an Verbindungen zwischen Widerständen der Spannungsteilereinheit angeschlossen sind und über eine Auswahleinheit ein nichtinvertierender Eingang auswählbar ist und
- daß die Spannungsteilereinheit und der zweite Widerstand an ein einstellbares, rauscharmes Bezugspotential angeschlossen sind.

2. Schaltungsanordnung nach Anspruch 1, **dadurch gekennzeichnet, daß** die Auswahleinheit ein I²C-Bus ist.

3. Schaltungsanordnung nach Anspruch 2 **dadurch gekennzeichnet, daß** Eingangstransistorenpaare der nichtinvertierenden Eingänge der ersten Verstärkerstufe von der Auswahleinheit über Stromquellentransistoren wählbar sind.

4. Schaltungsanordnung nach Anspruch 1 **dadurch gekennzeichnet, daß** die Spannungsteilereinheit eine nichtlineare Aufteilung aufweist.

5. Schaltungsanordnung nach Anspruch 1 **dadurch gekennzeichnet, daß** eine zweite Verstärkerstufe, die einen nichtinvertierenden Eingang, einen invertierenden Eingang und einen Ausgang aufweist, zum Verstärken eines Eingangssignals vorgesehen ist und am Ausgang dieser Verstärkerstufe die Aufteilung in Haupt- und Nebenpfad erfolgt, wobei ein Ausgangssignal vom Ausgang der zweiten Verstärkerstufe auf ihren nichtinvertierenden Eingang gegengekoppelt ist, das Eingangssignal der zweiten Verstärkerstufe am nichtinvertierenden Eingang zugeführt wird und der invertierende Eingang mit einer externen Referenzspannung, welche zwischen einer Betriebsspannung und Masse liegt, angesteuert wird.

6. Schaltungsanordnung nach Anspruch 5, **dadurch gekennzeichnet, daß** das Bezugspotential mit einer dritten Verstärkerstufe gebildet wird, wobei die dritte Verstärkerstufe an ihrem nichtinvertierenden Eingang mit dieser Referenzspannung angesteuert wird und ein das Bezugspotential darstellender Ausgang der dritten Verstärkerstufe auf ihren invertierenden Eingang gegengekoppelt ist.

7. Rundfunkempfänger, **gekennzeichnet durch** eine Schaltungsanordnung nach einem der Ansprüche 1 bis 6.

## Claims

1. A circuit arrangement for an adjustable high-pass filter, comprising
- a main path for conveying a main current, including a first resistor which is connected at the output to a sum node,
- a sub-path for conveying a sub-current via a voltage divider unit, a first amplifier stage, whose output is coupled to inverting inputs of the first amplifier stage, and a capacitor which is arranged between the output of the first amplifier stage and the sum node,
- a second resistor which is connected to the sum node, with the main current and the sub-current being added at the sum node, **characterized in that**
- non-inverting inputs of the first amplifier stage are connected to connections between resistors of the voltage divider unit, and a non-inverting input is selectable via a selection unit, and
- the voltage divider unit and the second resistor are connected to an adjustable, low-noise reference potential.

2. A circuit arrangement as claimed in claim 1, **characterized in that** the selection unit is an I²C bus.

3. A circuit arrangement as claimed in claim 2, **characterized in that** input transistor pairs of the non-inverting inputs of the first amplifier stage are selectable by the selection unit via current source transistors.

4. A circuit arrangement as claimed in claim 1, **characterized in that** the voltage divider unit has a non-linear division.

5. A circuit arrangement as claimed in claim 1, **characterized in that** a second amplifier stage having a non-inverting input, an inverting input and an output is provided for amplifying an input signal, and a division into a main path and a sub-path is effected at the output of said amplifier stage, with an output signal from the output of the second amplifier stage being negatively fed back to its non-inverting input, the input signal of the second amplifier stage being applied to the non-inverting input, and the inverting input being controlled by means of an external reference voltage between an operating voltage and ground.

6. A circuit arrangement as claimed in claim 5, **characterized in that** the reference potential is constituted by a third amplifier stage whose non-inverting input is controlled by means of said reference voltage, and an output, representing the reference potential, of the third amplifier stage is negatively fed back to its inverting input.

7. A radio receiver, **characterized by** a circuit arrangement as claimed in any one of claims 1 to 6.

## Revendications

1. Circuit pour un filtre passe-haut réglable qui contient :
- une voie principale pour conduire un courant principal avec une première résistance qui est raccordée côté sortie à un noeud de somme,
- une voie accessoire pour conduire un courant accessoire par l'intermédiaire d'une unité de diviseur de tension, un premier étage amplificateur dont la sortie est couplée aux entrées inversantes du premier étage amplificateur et un condensateur qui est monté entre la sortie du premier étage amplificateur et le noeud de somme,
- une deuxième résistance qui est raccordée au noeud de somme, le courant principal et le courant accessoire étant additionnés sur le noeud de somme,
**caractérisé en ce que**
- les entrées non-inversantes du premier étage amplificateur sont respectivement raccordées aux jonctions entre les résistances de l'unité de diviseur de tension et une entrée non-inversante peut être sélectionnée par l'intermédiaire d'une unité de sélection et - l'unité de diviseur de tension et la deuxième résistance sont raccordées à un potentiel de référence réglable et à faible bruit.

2. Circuit selon la revendication 1, **caractérisé en ce que** l'unité de sélection est un bus I²C.

3. Circuit selon la revendication 2, **caractérisé en ce que** les paires de transistors d'entrée des entrées non-inversantes du premier étage amplificateur peuvent être sélectionnées par l'unité de sélection par l'intermédiaire de transistors de sources de courant.

4. Circuit selon la revendication 1, **caractérisé en ce que** l'unité de diviseur de tension présente une répartition non-linéaire.

5. Circuit selon la revendication 1, **caractérisé en ce qu'**un deuxième étage amplificateur qui présente une entrée non-inversante, une entrée inversante et une sortie est prévu pour l'amplification d'un signal d'entrée et la répartition en voies principale et accessoire se produit à la sortie de cet étage amplificateur, un signal de sortie étant contre-couplé de la sortie du deuxième étage d'amplificateur sur son entrée non-inversante, le signal d'entrée du deuxième étage amplificateur est amené à l'entrée non-inversante et l'entrée inversante est commandée avec une tension de référence externe qui se situe entre une tension de fonctionnement et la masse.

6. Circuit selon la revendication 5, **caractérisé en ce que** le potentiel de référence est formé avec un troisième étage amplificateur, le troisième étage amplificateur étant commandé à son entrée non-inversante avec cette tension de référence et une sortie du troisième étage d'amplificateur représentant le potentiel de référence étant contre-couplée sur son entrée inversante.

7. Récepteur radio **caractérisé par** un circuit selon l'une des revendications 1 à 6.
